# EUROPÄISCHE PATENTSCHRIFT

(11) **EP 0 274 725 B1**
(45) Veröffentlichungstag und Bekanntmachung des Hinweises auf die Patenterteilung: **06.10.1993**
(21) Anmeldenummer: 87119020.3
(22) Anmeldetag: 22.12.1987
(51) Int. Cl.: H03K 17/969

(54) **Optoelektronische Tastatur**
Opto-electronic keyboard
Clavier opto-électronique

(30) Priorität: 14.01.1987 DE 3700856
(43) Veröffentlichungstag der Anmeldung: 20.07.1988
(73) Patentinhaber: TEMIC TELEFUNKEN microelectronic GmbH, 74072 Heilbronn (DE)
(72) Erfinder: Haag, Ernst, Dr., D-7100 Heilbronn (DE); Haag, Günter, Dr., D-7000 Stuttgart 80 (DE); Leitner, Georg, D-8500 Nürnberg 60 (DE); Farnbauer-Schmidt, Konrad, D-8560 Lauf (DE)
(74) Vertreter: Maute, Hans-Jürgen, Dipl.-Ing.

(56) Entgegenhaltungen:
- EP-A- 0 004 520
- EP-A- 0 054 644
- EP-A- 0 151 022
- EP-A- 0 200 513
- WO-A-86/01954
- WO-A-86/03316
- DE-A- 3 017 309
- DE-A- 3 307 334
- DE-A- 3 307 336
- DE-C- 3 319 334
- DE-C- 3 432 100
- GB-A- 1 238 428
- GB-A- 1 563 748
- US-A- 4 417 824

## Beschreibung

Die Erfindung betrifft eine optoelektronische Tastatur gemäß dem Oberbegriff des Patentanspruchs 1. Eine derartige Tastatur ist aus der EP 0 151 022 bekannt.
Aus der GB 1 238 428 ist ein Dateneingabesystem mit einer optoelektronischen Tastatur bekannt, bei dem jeder Taste ein Empfangselement zugeordnet ist und bei der die Auswerteschaltung im Grundgehäuse untergebracht ist.
In der US-PS 4 417 824 wird eine optische Tastatur mit einer Vielzahl von lichtaussendenden Elementen beschrieben, bei der eine Auswertung verschiedener Multiplexzyklen unter Zuhilfenahme eines Speichers vorgenommen wird.

Der Erfindung liegt die Aufgabe zugrunde, eine optoelektronische Tastatur anzugeben, die höchste Zuverlässigkeit aufweist und die gegenüber mechanischen, elektrischen und elektromagnetischen externen Einflüssen bestens abgeschirmt ist.
Diese Aufgabe wird durch die Merkmale des Patentanspruchs 1 gelöst.

Bei der erfindungsgemäßen optoelektronischen Tastatur ist wesentlich, daß das die Tastatur enthaltende und nur aus mechanischen Teilen bestehende Oberteil des Gehäuses von dem die elektronischen Bauelemente und gegebenenfalls die Auswerteelektronik enthaltenden Teil so getrennt ist, daß weder externe mechanische Einflüsse noch elektrische oder elektro-magnetische Einwirkungen die Tastatur beeinflussen können. Der mechanische Teil und der elektrische Teil der Tastatur kann so getrennt aufgebaut und danach zu einer gebrauchsfähigen Einheit zusammengesetzt werden.
Ein weiterer wesentlicher Gedanke der Erfindung besteht darin, daß die Zahl der elektronischen Bauelemente, insbesondere der Empfangselemente, durch den Multiplex-Betrieb und auch durch die spezielle Anordnung der Bauelemente erheblich reduziert werden kann. In Einzelfällen sind nur 1 oder 2 Detektorelemente erforderlich. Die Erfindung hat den weiteren Vorteil, daß die gesamte Auswerteelektronik innerhalb des Grundkörpers der Tastatur angeordnet werden kann, so daß in dem vom Tastenfeld abgeschirmten Raum auf geeignet angeordneten Platinen die Sendeelemente, die Empfangselemente und die Auswerteelektronik untergebracht und miteinander verschaltet sind. In diesem Fall werden die Sende- und Empfangsbauelemente vorzugsweise als SMD-Bauelemente ausgebildet. Für die Strahlungsführung ist ein gesonderter Bereich in der flach ausgebildeten Tastatur vorgesehen, der über Öffnungen oder Fenster in der Abschirmung an die Sende- und Empfangselemente angekoppelt ist.
Die Tastatur ist vorzugsweise so ausgebildet, daß die Tastenstößel bei Betätigung der Tasten in geeigneter Weise Einfluß auf die Lichtführung nehmen, so daß Signaländerungen auftreten, die zur Identifizierung einer oder mehreren betätigten Tasten führen.

Für die Ansteuerung der Sendeelemente kann ein Zeit- oder Frequenzmultiplex-Betrieb oder ein spezieller Mischbetrieb gewählt werden, wobei die durch die Empfangselemente aufgenommenen Signalverläufe verschiedener Multiplex-Zyklen abgespeichert und in einer nachgeschalteten Auswerteschaltung miteinander verglichen werden. Es besteht auch die Möglichkeit, durch den einzelnen Tasten zugeordnete, fest vorgegebene Schwellwerte bei jedem Multiplex-Zyklus eine Erkennungsabfrage der Tasten vorzunehmen.

Weitere vorteilhafte Ausgestaltungen der Erfindung ergeben sich aus den Unteransprüchen.

Die Erfindung und ihre vorteilhaften Ausgestaltungen sollen im weiteren noch anhand von mehreren Ausführungsbeispielen erläutert werden.
Die Figur 1 zeigt in einer Draufsicht und die Figur 2 im Schnitt eine Ausführungsform eines Tastenfeldes, bei dem durch Betätigen einer Taste bestimmte Empfangselemente abgeschattet werden.
Figur 3 zeigt in der Draufsicht und Figur 4 im Schnitt eine andere Ausführungsform eines Tastenfeldes, bei der beim Betätigen einer Taste der von einem Sendeelement ausgehende Lichtstrahl zu einem Empfangselement umgelenkt wird.
Figur 5 zeigt eine spezielle Ausführungsform für Sende- und Empfangselemente aus Endstücken von Lichtleitern. Figur 6 zeigt die Ausbildung einer Taste.
Figur 7 zeigt in der Draufsicht und Figur 8 im Schnitt eine weitere Ausführungsform für ein Tastenfeld, bei dem jeder Taste ein Sendeelement zugeordnet wird und durch Betätigen einer Taste die aufgenommene Lichtintensität an einem oder mehreren Empfangselementen verändert wird.
Figur 9 zeigt die Ausbildung einer Taste, wie sie für ein Tastenfeld gemäß Figur 7 und 8 geeignet ist.
Die Figuren 10 und 11 zeigen charakteristische Signalverläufe bei gedrückten und nicht gedrückten Tasten.
Figur 12 zeigt den Prinzipaufbau der Auswerteschaltung und der Ansteuerschaltung für die optoelektronische Tastatur.

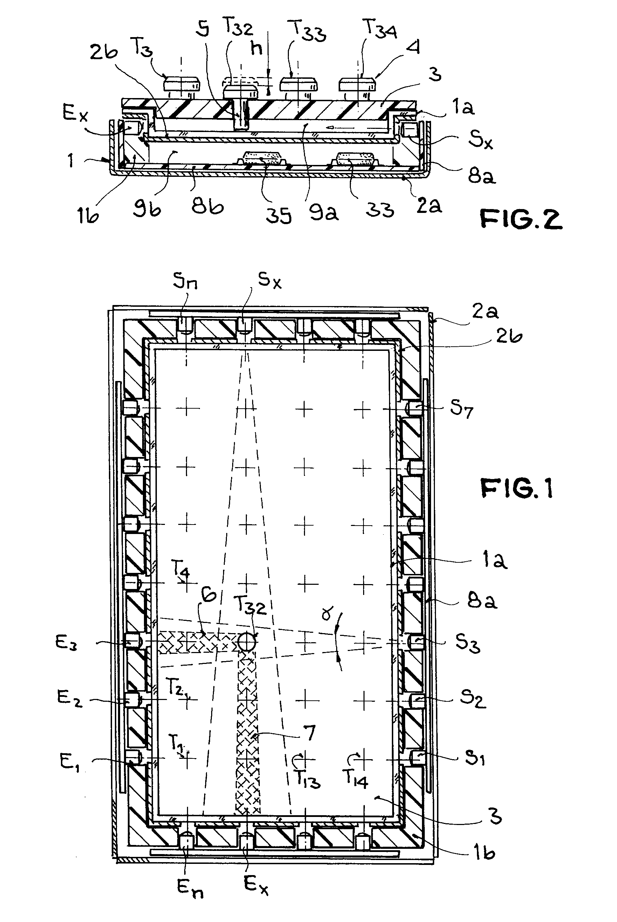

Bei dem Tastenfeld gemäß Figur 1 enthält ein Grundkörper 1 die Sendeelemente S und die Empfangselemente E sowie im dargestellten Ausführungsbeispiel Bauteile 33 und 35 der Auswerteelektronik. Der Grundkörper ist mit einer Abdeckung 3 bedeckt, die der Tastenführung der mechanisch betätigbaren Tasten dient. Die Tasten selbst bestehen hier vereinfacht dargestellt aus einem Tastenkopf 4 und einem Tastenstößel 5; der Tastenhub ist in der Figur 2 mit h bezeichnet.

Wie ersichtlich, sind die Sendeelemente S und die Empfangselemente E in einem das Tastenfeld umschließenden Teil 1b des Grundkörpers untergebracht. Dieser Teil 1b des Grundkörpers besteht beispielsweise aus isolierendem Material und enthält Ausparungen für die Aufnahme der Sendeelemente S und der Empfangselemente E. Die Sendeelemente und die Empfangselemente sind im Ausführungsbeispiel so angeordnet, daß 2 Randteile des rechteckförmigen Grundkörpers 1b Sendeelemente S und die gegenüberliegenden beiden Randteile Empfangselemente E aufweisen. Sendeelemente sind beispielsweise Lumineszenzdioden, während als Empfangselemente Fotodetektoren, wie Fotodioden oder Fototransistoren, in Frage kommen.

Der für die Strahlungsführung vorgesehene Raum 9a wird einerseits durch die Abdeckung 3 und andererseits durch ein wannenförmiges Teil 1a begrenzt, wobei die Wannentiefe etwa dem Schalthub h der Tasten entspricht. Die für die verwendete Strahlung transparent ausgeführte Wanne 1a und die Abdeckung 3 bestehen vorzugsweise aus isolierendem Material. Sende- und Empfangselemente S bzw. E sind so in das Randteil 1b eingelassen, daß der Strahlengang zwischen diesen Bauelementen in dem der Strahlungsführung dienenden Raum 9a verläuft, wobei der Lichtstrahl durch lichtdurchlässige Fenster in der metallischen Abschirmung 2b ein- bzw. austritt.

Die Sende- und Empfangselemente S bzw. E sind vorzugsweise auf Platinen 8a montiert, auf denen auch die Signalleitungen zur Auswerteelektronik verlaufen. Die Auswerteelektronik 33 bzw. 35 wird vorzugsweise unterhalb der Wanne 1a angebracht, wobei diese elektronischen Bauteile gleichfalls auf Platinen 8b angeordnet werden, die Signalleitungen und Verknüpfungsleitungen aufweisen und mit den zugeordneten Signalleitungen auf der Platine 8a verschaltet sind. Bei der dargestellten Ausführungsform verlaufen die Platinen 8a und 8b senkrecht zueinander und bilden zusammen mit den Randteilen 1b des Grundkörpers und der Wanne 1a einen abgeschlossenen Raum, der alle elektronischen Bauteile S, E 33 und 35 sowie alle Signalleitungen und Verbindungsleitungen enthält. Dieser abgeschlossene Raum 9b wird vorzugsweise allseitig mit einer metallischen Abschirmung 2a und 2b versehen, durch die die elektronischen Bauteile gegen externe Einflüsse und gegen elektromagnetische Strahlungen vollständig abgeschirmt werden. Diese Abschirmung kann aus Metallblechen oder aus Metallbeschichtungen bestehen. In dieser Abschirmung müssen allerdings Öffnungen oder Fenster in der Weise vorgesehen werden, so daß der Strahlengang zwischen Sende- und Empfangselementen nicht behindert wird.
Wie aus der Figur 1 ersichtlich, emittieren die Sendeelement S ein Strahlungsbündel mit dem Öffnungswinkel α. Dieser Öffnungswinkel wird vorzugsweise klein gewählt, um eine gute abschattende Wirkung durch den Tastenstößel bei Betätigen einer definierten Taste zu erzielen. Beim dargestellten Ausführungsbeispiel ist die Taste T₃₂ betätigt, so daß der vom Sendebauelement S₃ ausgehende Lichtstrahl 6 gegenüber dem Empfangselement E₃ abgeschattet wird. Gleiches gilt für den vom Sendeelement Sₓ ausgehende Lichtstrahl 7, der gegenüber dem Empfangselement Eₓ abgeschattet wird. Durch die festgestellten reduzierten Signalwerte bei E₃ und bei Eₓ ist eindeutig die Taste T₃₂ als betätigt definiert.

Die Abdeckung 3 wird vorzugsweise abnehmbar ausgebildet, so daß ein Reinigen der Tasten T bzw. des gesamten Oberteils der optoelektronischen Tastatur leicht möglich ist. Bei diesem Reinigungsvorgang wird der elektronische Teil der Tastatur nicht beeinträchtigt. Die Wanne 1a schützt alle darunterliegenden Teile vor Feuchtigkeit, Flüssigkeiten oder mechanischen Beschädigungen. Die einzelnen Sendeelemente S und die Empfangselemente E werden von einer im Detail hier nicht näher beschriebenen Ansteuerschaltung über Signalleitungen im Multiplex-Betrieb angesteuert bzw. abgefragt. Es ist sowohl ein Zeitmultiplex-Betrieb als auch ein Frequenzmultiplex-Betrieb denkbar. Die Auswertung der mittels der Empfangselemente E empfangenen Signale kann durch Hintereinanderschaltung der Empfangselemente bzw. Zusammenfassung ihrer Signale erheblich vereinfacht werden.

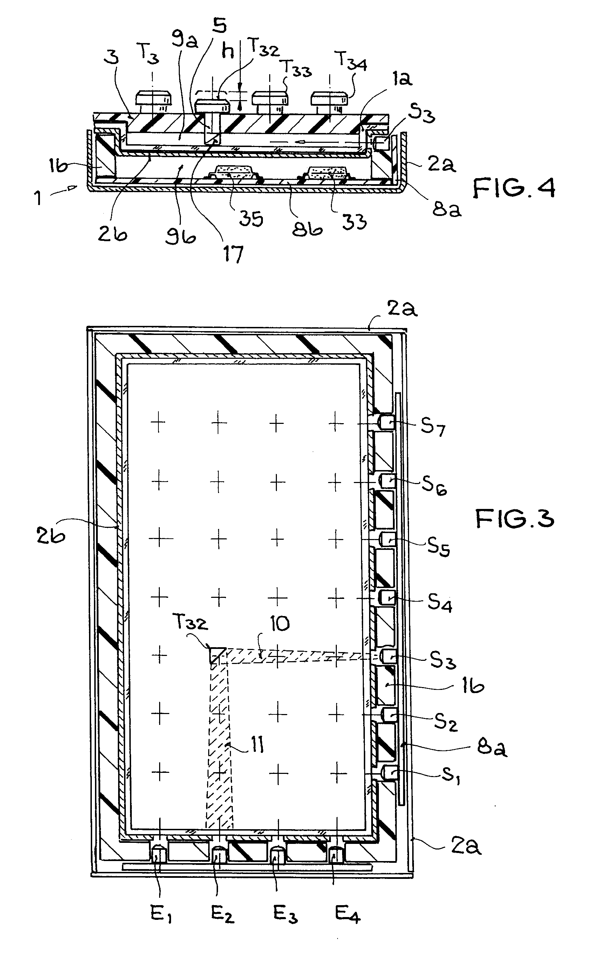

Bei der Tastatur nach den Figuren 1 und 2 ist die Anzahl der verwendeten Sende- bzw. Empfangselemente kleiner als die Anzahl der betätigbaren Tasten. Dies ist ein wesentliches Kriterium für die Herstellung kostengünstiger Tastaturen. Das Ausführungsbeispiel nach den Figuren 3 und 4 benötigt noch weniger Sende- und Empfangselemente.

Bei der Anordnung in Figur 3 und 4 sind für die der Anordnung nach Figur 1 und 2 entsprechenden Teil gleiche Bezugsziffern gewählt, so daß auf eine nochmalige Erläuterung dieser Bauteile verzichtet werden kann. Im Unterschied zu der Anordnung nach der Figur 1 und 2 werden nun nur an einer Randseite des Grundkörperteils 1b Sendebauelemente S₁ bis S₇ untergebracht. An einer hierzu senkrecht verlaufenden Randseite werden Empfangselemente E₁ - E₄ angeordnet. Die Tastenstößel sind an ihrem den Strahlengang beeinflussenden Teil 17 so ausgebildet, daß bei betätigter Taste der von einem Sendebauelemente S₃ ausgehende Lichtstrahl 10 um 90° umgelenkt wird und so als Lichtstrahl 11 auf das Empfangselement E₂ auftrifft. Das Stößelende 17 ist in diesem Fall als 90°-Winkelspiegel ausgebildet. Wenn folglich, wie im Ausführungsbeispiel dargestellt, die Taste T₃₂ gedrückt wird, steigt das Eingangssignal im Empfangsbauelement E₂ stark an, so daß bei einer durch die Taktzeit definierten Emissionszeit des Bauelementes S₃ die Taste T₃₂ als betätigt ermittelt werden kann. Die separat nicht dargestellte Ansteuerschaltung un die zugehörige Auswerteschaltung wird wieder vorzugsweise, wie in Figur 4 dargestellt, im geschützten und abgeschirmten Unterteil 1 der optoelektronischen Tastatur untergebracht. Nacheinander werdent die einzelnen Sendeelemente S₁ - S₇ über zugehörige Signalleitungen angesteuert und entsprechende Lichtimpulse ausgesendet. Die verschiedenen Empfangselemente E₁ - E₄ übertragen mittels angeschlossener Signalleitungen die aufgenommenen Signale zur Auswerteschaltung, welche, wie dargelet, ein einer gedrückten Taste entsprechendes Signal liefert bzw. eine entsprechende Anzeige ausgibt.

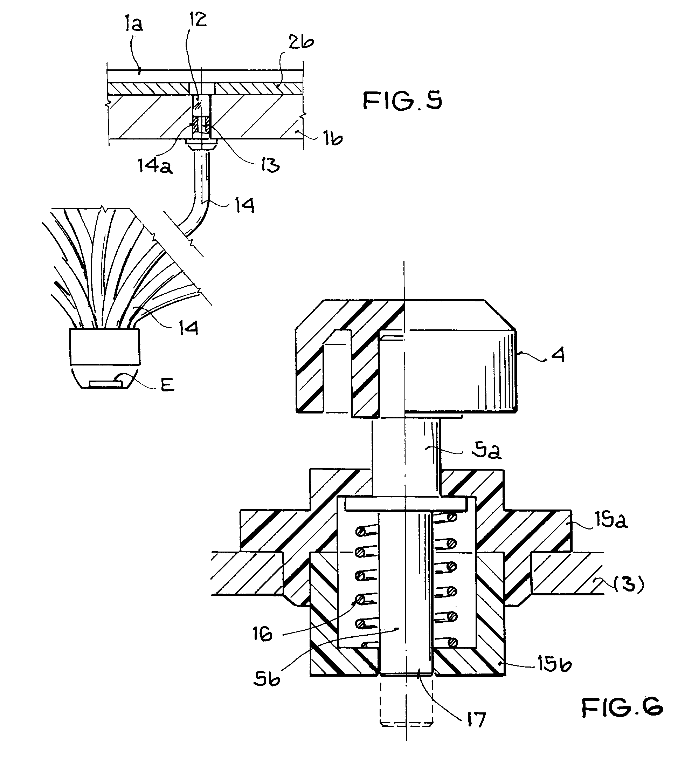

Wie bereits dargelegt, werden als Sendebauelemente vorzugsweise Elektrolumineszenzioden, als Empfangselemente Fotodioden oder Fototransistoren verwendet. Es besteht, wie in Figur 5 dargestellt, jedoch auch die Möglichkeit, die Sende- und Empfangselemente mit Hilfe der Lichtleitertechnik zu realisieren. Ein Empfangselement besteht dann beispielsweise aus dem Endstück 13 eines Lichtleiters, das in einer Hülse 14a gefaßt ist, die ihrerseits wiederum in einer Aussparung 12 des Grundkörperteils 1b angeordnet ist. Das Lichtleiterkabel 14 führt zu einem Empfangselement E, das an geeigneter Stelle in der optoelektronischen Tastatur untergebracht ist. Wie in der Figur 5 angedeutet, können zu einem Empfangselement eine Vielzahl von Lichtleitern 14 führen, da die Signalabfrage des Empfangselementes E im Multiplex-Betrieb erfolgt.

Die Figur 6 zeigt den Aufbau einer Einzeltaste. Der Tastenkopf 4 ist fest mit dem Tastenstößel 5a verbunden. Dieser Tastenstößel wird im Bereich 5b beweglich in einem zweiteiligen Tastenunterteil 15a und 15b geführt. Durch die Feder 16 wird ohne zusätzliches Aufbringen von äußerer Kraft der Stößel 5 bis zum Anschlag nach oben gedrückt. Durch Betätigen der Taste wird der Stößel 5 nach unter geführt, so daß das untere Ende 17 des Stößels in den für die Strahlenführung vorgesehenen Raum eindringt und dort den Strahlengang beeinflußt. Beim Ausführungsbeispiel in Figur 6 ist das Stößelende 17 zylinderförmig ausgebildet, so daß es zur Unterbrechung eines vorhandenen Lichtstrahls geeignet ist. Durch Ausbildung als Winkelspiegel in diesem Teil wird eine Umlenkung des Lichtes vorgenommen.

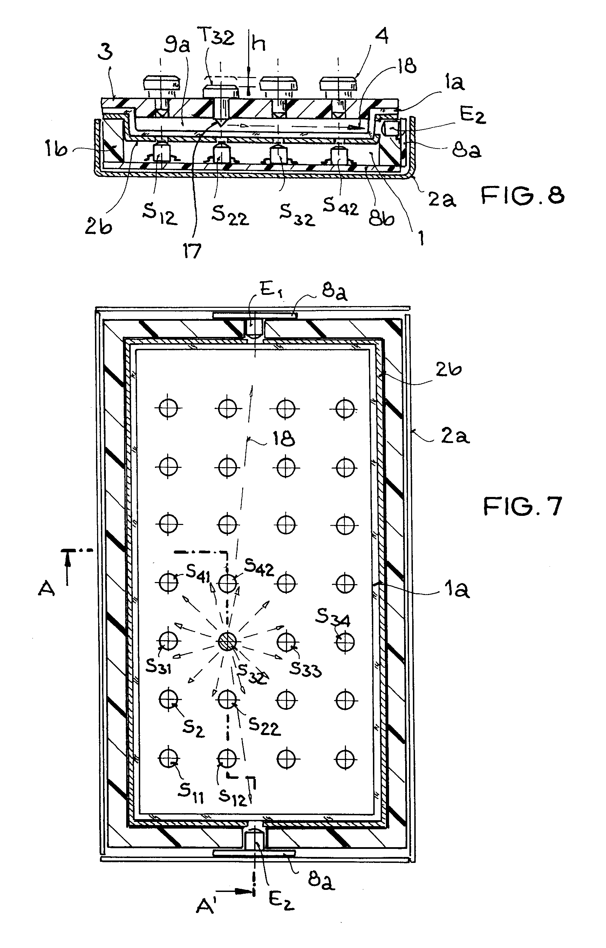

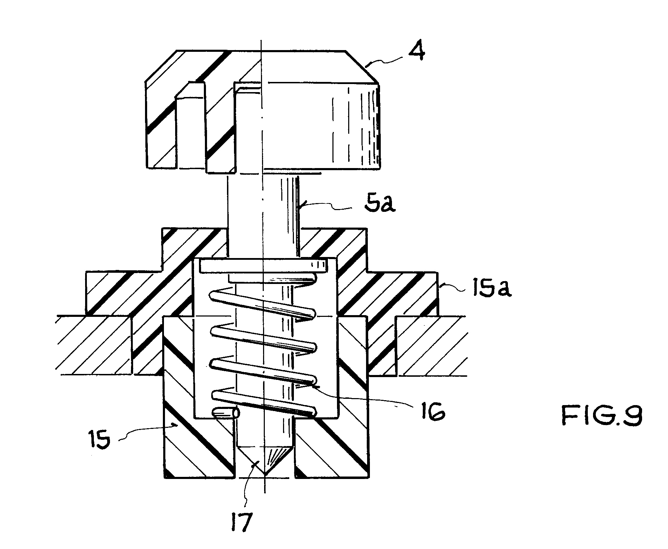

Bei der optoelektronischen Tastatur nach den Figuren 7 und 8 ist unterhalb jeder Taste ein Sendeelement S angeordnet. Die Sendeelemente sind beispielsweise als SMD-Bauelemente auf der Trägerplatine 8b untergebracht, auf der an geeigneter Stelle auch die Auswerteelektronik vorgesehen sein kann. Der von den Sendeelementen S ausgehende divergente Lichtstrahl tritt durch Fenster oder Öffnungen in der Abschirmung 2b und dem Boden der Wanne 1a in den für die Lichtführung vorgesehenen Raum 9a ein. Bei nichtbetätigten Tasten wird das eintretende Licht weitgehend von der Abdeckung 3 absorbiert. Wenn, wie in Figur 7 dargestellt, beispielsweise die Taste T₃₂ gedrückt wird, erfolgt eine Reflexion des vom Sendeelement S₃₂ ausgehenden Lichtstrahls an dem kegelförmig ausgebildeten Stößelende 17, so daß deutlich erhöhte und damit erkennbare Strahlenanteile 18 zu den Empfangselementen E₁ bzw. E₂ gelangen. Im Ausführungsbeispiel sind 2 Empfangselemente E₁ und E₂ an einander gegenüberliegenden Seitenteilen im Grundkörperteil 1b untergebracht. Selbstverständlich reicht auch 1 Empfangselement aus, oder es können auch weitere Empfangselemente verwendet werden, wenn bei der Signalerkennung eine entsprechende Redundanz gewünscht wird. Auch bei der Anordnung nach den Figuren 7 und 8 ist eine vollständige Abschirmung des die elektronischen Bauelemente und die Auswerteschaltung enthaltenden Teils möglich, so daß die Tastatur selbst under extremen Umweltbedingungen oder in Flüssigkeiten eingesetzt werden kann. Die das Tastenfeld enthalttende Abdeckung 3 kann vorzugsweise vom Grundkörper 1 entfernt werden, so daß ohne Einflußnahme auf die elektronischen Teil eine Trennung zwischen mechanischem Tastenfeld und Elektronikbereich möglich ist. Auf diese Weise kann die optoelektronische Tastatur leicht gereinigt oder beschädigte Tasten T ausgewechselt werden.

Beim Zeitmultiplex-Betrieb erfolgt eine Ansteuerung der Tastatur nach den Figuren 7 und 8 in der Weise, daß die einzelnen Sendeelemente nacheinander angeregt werden. Über die Empfangselemente E₁ und E₂ wird dann bei einer gedrückten Taste in dem zugeordneten Zeitraum eine Signalerhöhung festgestellt. Dieses Ermittlungsverfahren ist immer eindeutig, selbst dann, wenn mehrere Tasten gleichzeitig gedrückt werden. Wenn, wie in der Figur 7 dargestellt, 2 Empfangselemente vorgesehen sind, können die Eingangssignale addiert einer Auswerteschaltung zugeführt werden. Bei gedrückter Taste wird der durch das Streulicht vorgegebene Lichtanteil 18 über eine definierte Schwelle angehoben.

In Figur 9 ist nochmals eine Einzeltaste dargestellt, die sich von der Einzeltaste der Figur 6 dadurch unterscheidet, daß das den Strahlengang beeinflussende Stösselende 17 kegelförmig ausgebildet ist. Durch diesen Kegel wird das auftreffende Licht radialsymmetrisch abgelenkt, wie dies in der Figur 7 angedeutet ist. Für das Stößelende 17 kann jedoch auch eine andere Formgebung gewählt werden, wobei insbesondere angestrebt wird, das auftreffende Licht so umzulenken, daß eine Bündelung erfolgt und der abgelenkte Lichtstrahl parallel zur Abdeckung 3 (Figur 8) verläuft.

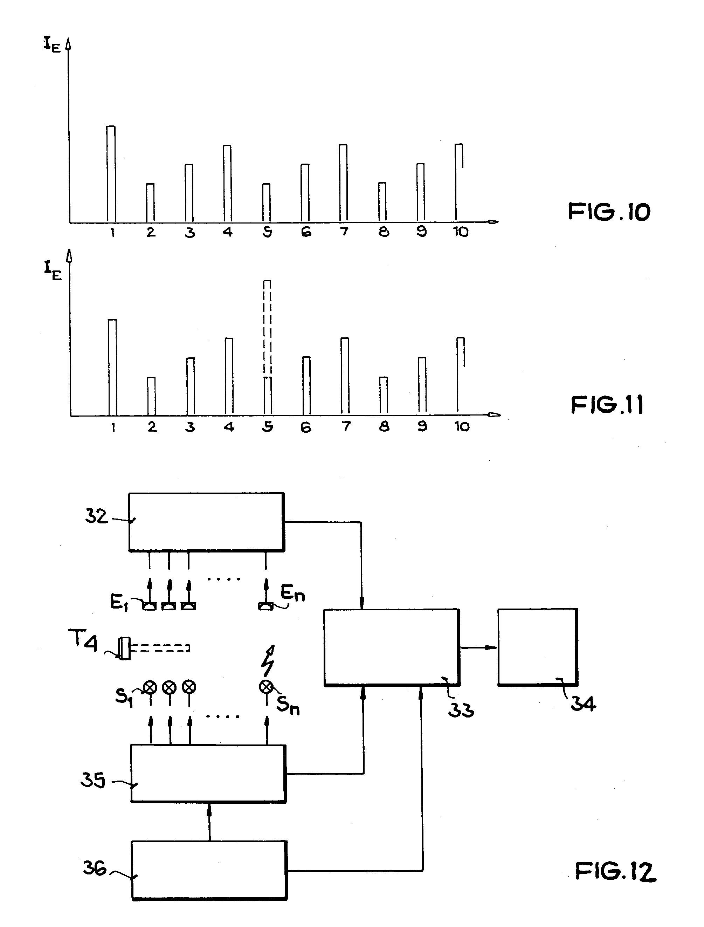

In Figur 10 ist ein möglicher Signalverlauf, gemessen am Eingang der Empfangselemente E, bei nicht gedrückten Tasten 1 - 10 dargestellt. In einem ersten Zyklus können diese Werte innerhalb eines Multiplex-Betriebes erfaßt und abgespeichert werden. Die erfaßten Signale werden dann mit entsprechenden Signalwerten der Sendeelemente in einem zweiten oder späteren Multiplex-Zyklus verglichen. Ein derartiger zweiter Multiplex-Zyklus ist in Figur 11 dargestellt. Wie ersichtlich, hat sich das Empfangssignal nur bei der Ansteuerung des Sendeelements 5 in der gestrichelt angedeuteten Weise geändert. Diese Signalerhöhung wird durch die betätigte zugeordnete Taste ausgelöst. Die Signalehöhung ist deutlich, so daß eine Identifizierung des Tastvorgangs sicher möglich ist.

In Figur 12 ist ein möglicher Prinzipaufbau der Auswerteschaltung und der Ansteuerschaltung für die optoelektronische Tastatur dargestellt. Über die Impulse des Taktgenerators 36 werden mittels der Ansteuerschaltung 35 die einzelnen Sendeelemente S₁ - Sₙ im Multiplex-Betrieb angesteuert. Die Signale der Empfangselemente E₁ - Eₙ werden über Signalleitungen der Signalaufbereitungseinrichtung 32 zugeführt, deren Aufgabe es ist, die einzelnen analogen Signale geeignet aufzubereiten, beispielsweise ein Summensignal zu erzeugen und dieses gegebenenfalls zu filtern. In den meisten Fällen ist eine nachfolgende Digitalisierung des empfangenen Signals zweckmäßig. Der Ausgang der Signalaufbereitungseinrichtung 32 ist mit der Auswerteeinrichtung 33 verbunden, die ferner vom Taktgenerator 36 angesteuert wird. Bei Zeitmultiplex-Betrieb werden die einzelnen Sendeelemente S₁ - Sₙ nacheinander angesteuert und die zugehörigen Signale über die Empfangselemente E₁ - Eₙ aufgenommen, digitalisiert, in der Auswerteeinrichtung 33 abgespeichert und die abgespeicherten Signalwerte mit entsprechenden Signalwerten nach einem oder mehreren weiteren Multiplex-Zyklen verglichen. Findet etwa durch Betätigen einer Taste T4 eine charakteristische Signaländerung statt, die nicht auf ein alleiniges optisches Rauschen zurückzuführen ist, wird diese Veränderung der entsprechenden Taste zugeordnet und über die Einrichtung 34 gemeldet.

Die Ansteuer- und Auswerteelektronik läßt sich einfach durch den Einsatz eines Mikrocomputers realisieren. Da keine mechanischen Kontakte verwendet werden, ist die Lebensdauer der optoelektronischen Tastatur durch die Lebensdauer der elektronischen Bauelemente bestimmt und damit sehr hoch.

Beim Frequenzmultiplex-Betrieb werden die Sendeelemente S₁ - Sₙ jeweils mit unterschiedlichen Frequenzen angesteuert. Die durch die Empfangselemente E₁ - Eₙ registrierte Frequenzmischung wird in der Signalaufbereitungseinrichtung 32 bezüglich des prozentualen Anteils der einzelnen Frequenzen untersucht. Die Veränderung der Intensitäten bei einzelnen Frequenzen des Frequenzgemisches ermöglicht es, eindeutig auf die gedrückte Taste des Tastenfeldes zu schließen. Die momentanen Werte der Intensitäten der einzelnen Frequenzen werden vorzugsweise wiederum digital abgespeichert. Die weitere Auswertung erfolgt wie im Zeitmultiplex-Betrieb.

## Patentansprüche

1. Optoelektronische Tastatur mit:
a) einem Grundkörper (1), der eine die Tastatur enthaltende Abdeckung (1a, 2b, 3) aufweist,
b) im Grundkörper (1) angeordneten Sendeelementen (S) und Empfangselementen (E),
c) Tasten (T) bzw. Tastenstößel (5), die eine derartige Formgebung aufweisen, daß bei einer Betätigung der Taste (T) der Strahlengang zwischen Sendeelementen (S) und Empfangselementen (E) beeinflußt und durch die Veränderung des Lichtstromes ein die betätigte Taste definierendes Signal erhalten wird,
d) einer Ansteuerschaltung (35), die die einzelnen Sendeelemente (S) im Zeitmultiplexbetrieb ansteuert,
e) einer Auswerteschaltung (33), die der Ansteuerschaltung (35) nachgeschaltet ist,
gekennzeichnet durch:
f) der der Strahlungsführung dienende Raum (9a) ist innerhalb der Abdeckung (1a, 2b, 3) von dem die Auswerteschaltung (33), die Sendeelemente (S) und die Empfangselemente (E) aufnehmenden Raum (9b) im Grundkörper (1) durch einen dem Grundkörper zugewandten Teil der Abdeckung (1a, 2b, 3) getrennt und optisch sowie elektromagnetisch abgeschirmt,
g) die Ansteuerschaltung (35) steuert die Sendeelemente (S) entweder im Zeitmultiplexbetrieb oder im Frequenzmultiplexbetrieb,
h) entweder werden die durch die Empfangselemente (E) aufgenommenen und abgespeicherten Signalverläufe verschiedener Multiplexzyklen in der Auswerteschaltung (33) miteinander verglichen, wobei entsprechende Signaländerungen zur Identifizierung einer oder mehrerer betätigten Tasten führen,
i) oder durch den einzelnen Tasten zugeordnete, fest vorgegebene Schwellwerte erfolgt bei jedem Multiplexzyklus eine Erkennungsabfrage der Tasten (T).

2. Optoelektronische Tastatur nach Anspruch 1, dadurch gekennzeichnet, daß die Tastenstößel (5) in ihrem bei einer Tastenbetätigung dem Strahlengang zwischen Sendeelement (S) und Empfangselement (E) ausgesetzten Teil (17) eine derartige Formgebung aufweisen, daß das auftreffende divergente Strahlenbündel (24) in ein weitgehend paralleles, im wesentlichen parallel zur Abdeckung (3) verlaufendes Strahlenbündel (25) übergeführt wird.

3. Optoelektronische Tastatur nach Anspruch 2, dadurch gekennzeichnet, daß im Grundkörper (1) jeweils unter einer Taste in einer Vertiefung (2) ein Sendeelement (S) angeordnet ist, und daß die Stößelunterseite (17) und die Stößelumgebung (22) jeder Taste so ausgebildet ist, daß im Falle der nicht-betätigten Taste die vom zugeordneten Sendeelement (S) abgegebene Strahlung weitestgehend absorbiert wird, während bei gedrückter Taste die vom Sendeelement (S) abgegebene Strahlung am Stößel parallel zur Abdeckung (3) umgelenkt wird.

4. Optoelektronische Tastatur nach Anspruch 2 oder 3, dadurch gekennzeichnet, daß im Strahlengang des an den Tastenstößeln (5) umgelenkten Lichtstrahls am äußeren Rand der Tastatur ein Reflektor (23) angeordnet ist, durch den der Lichtstrahl auf mehrere im Grundkörper angeordnete Empfangselemente (E₁) derart umgelenkt wird, daß die Tastatur viele Sendeelemente (S) und wenig Empfangselemente (E) aufweist.

5. Optoelektronische Tastatur nach einem der Ansprüche 1 bis 4, dadurch gekennzeichnet, daß die Sendeelemente (S) und Empfangselemente (E) aus Lumineszenzdioden oder strahlungsempfindlichen Halbleiterdetektoren bestehen oder als wärmeempfindliche Sensoren ausgebildet sind oder als SMD-Halbleiterbauelemente auf der Grundfolie eines Folienschalters bzw. auf einem Grundträger angeordnet sind.

6. Optoelektronische Tastatur nach einem der Ansprüche 1 bis 5, dadurch gekennzeichnet, daß die jeweils einer Taste zugeordneten Sendeelemente (S) und Empfangselemente (E) in einem gemeinsamen Gehäusekörper (37) als Koppelelement in SMD-Technik untergebracht sind.

7. Optoelektronische Tastatur nach einem der vorangehenden Ansprüche, dadurch gekennzeichnet, daß die Sendeelemente (S) bzw. Empfangselemente (E) aus den Endpunkten (13) von Lichtleiterkabeln (14) bestehen, die an eine externe Ansteuer- und Auswerteelektronik angeschlossen sind.

8. Optoelektronische Tastatur nach einem der vorangehenden Ansprüche, dadurch gekennzeichnet, daß die Abschirmung (2a, 2b) aus einer Metallbeschichtung oder einer Metallfolie besteht, die den gesamten, die Auswerteelektronik aufnehmenden Raum (9b) umschließt und Öffnungen für den Lichteintritt bzw. Lichtaustritt aufweist.

9. Optoelektronische Tastatur nach einem der vorangehenden Ansprüche, dadurch gekennzeichnet, daß die Sendeelemente (S) im Frequenzmultiplexbetrieb mit unterschiedlichen Frequenzen angesteuert werden und die von den Empfangselementen (E) registrierten Frequenzmischungen in einer Signalaufbereitungseinrichtung (32) bezüglich der Anteile der einzelnen Frequenzen untersucht werden, so daß Veränderungen der Intensität einzelner Frequenzen des Frequenzgemisches auf eine Zustandsänderung der entsprechenden Taste schließen lassen.

## Claims

1. Optoelectronic keyboard with:
a) a base (1) having a cover (1a, 2b, 3) containing the keyboard,
b) transmitting elements (S) and receiving elements (E) arranged in the base (1),
c) keys (T) or key stems (5) which are shaped in such a way that when the key (T) is actuated the beam path between transmitting elements (S) and receiving elements (E) is influenced and a signal which defines the actuated key is obtained through the changed in the light flux,
d) a control circuit (35) which controls the individual transmitting elements (S) in time-division multiplex operation,
e) an evaluation circuit (33) which is connected after the control circuit (35),
characterised by:
f) inside the cover (1a, 2b, 3) the space (9a) which serves for guiding the beam is separated from the space (9b) which accommodates the evaluation circuit (33), the transmitting elements (S) and the receiving elements (E) in the base by a part of the cover (1a, 2b, 3) facing the base and is shielded both optically and electromagnetically,
g) the control circuit (35) controls the transmitting elements (S) either in time-division multiplex operation or in frequency-division multiplex operation,
h) either the signal patterns of different multiplex cycles which are received and stored by the receiving elements (E) are compared with one another in the evaluation circuit (33), in which case corresponding signal changes lead to the identification of one or more actuated keys,
i) or in each multiplex cycle an identity interrogation of the keys (T) takes place by means of fixed predetermined threshold values assigned to the individual keys.

2. Optoelectronic keyboard according to Claim 1, characterised in that the part (17) of the key stems (5) which is exposed to the beam path between transmitting element (S) and receiving element (E) during actuation of the key is shaped in such a way that the incident divergent beam (24) is converted into a largely parallel beam (25) running substantially parallel to the cover (3).

3. Optoelectronic keyboard according to Claim 2, characterised in that in the base (1) a transmitting element (S) is arranged in a depression (2) under each key, and that the end (17) and the surround (22) of the stem of each key are constructed so that in the case of a non-actuated key the radiation emitted by the associated transmitting element (S) is absorbed to the greatest possible extent, whereas in the case of a pressed key the radiation emitted by the transmitting element (S) is deflected on the stem parallel to the cover (3).

4. Optoelectronic keyboard according to Claim 2 or 3, characterised in that a reflector (23) is arranged on the outer edge of the keyboard in the path of the light beam deflected on the key stems (5), the light beam being deflected by the said reflector onto several receiving elements (E₁) arranged in the base in such a way that the keyboard has many transmitting elements (S) and few receiving elements (E).

5. Optoelectronic keyboard according to one of Claims 1 to 4, characterised in that the transmitting elements (S) and receiving elements (E) consist of light-emitting diodes or radiation-sensitive semiconductor detectors or are constructed as heat-sensitive sensors or are arranged as surface-mounted semiconductor components on the foil base of a foil circuit or on a substrate.

6. Optoelectronic keyboard according to one of Claims 1 to 5, characterised in that the transmitting elements (S) and receiving elements (E) associated with each key are accommodated in a common housing (37) as coupling element in surface mounting technology.

7. Optoelectronic keyboard according to one of the preceding claims, characterised in that the transmitting elements (S) or receiving elements (E) consist of the tips (13) of light guide cables (14) which are connected to an external control and evaluation electronic system.

8. Optoelectronic keyboard according to one of the preceding claims, characterised in that the shielding (2a, 2b) consists of a metal coating or a metal foil which surrounds the entire space (9b) accommodating the evaluation electronic system and has openings for the admission or exit of light.

9. Optoelectronic keyboard according to one of the preceding claims, characterised in that the transmitting elements (S) are controlled at different frequencies in frequency-division multiplex operation and the mixtures of frequencies registered by the receiving elements (E) are examined in a signal processor (32) as regards the proportions of the individual frequencies, so that changes in the intensity of individual frequencies in the mixture of frequencies indicate a change of state of the corresponding key.

## Revendications

1. Clavier opto-électronique comportant:
a) un élément de base (1) qui présente un capotage (1a, 2b, 3) contenant le clavier,
b) des éléments émetteurs (S) et des éléments récepteurs (E) disposés dans l'élément de base (1),
c) des touches (T) ou des tiges de touche (5), qui présentent une conformation telle que si l'on manoeuvre la touche (T), le chemin du faisceau entre les éléments émetteurs (S) et les éléments récepteurs (E) est influencé et que, du fait de la modification du flux lumineux, on obtient un signal définissant la touche manoeuvrée,
d) un circuit d'activation (35) qui active en multiplexage par répartition dans le temps les différents éléments émetteurs (S),
e) un circuit de traitement (33) monté en aval du circuit d'activation (35),
clavier caractérisé
f) par le fait que l'espace (9a) servant au passage du faisceau est, à l'intérieur du capotage (1a, 2b, 3), séparé, par une partie du capotage (1a, 2b, 3) correspondant au corps de base, d'avec l'espace (9b) qui, dans le corps de base (1), loge le circuit de traitement (33), les éléments émetteurs (S) et les éléments récepteurs (E), et qu'il en est protégé par un blindage au point de vue optique et électromagnétique.
g) par le fait que le circuit d'activation (35) active les éléments émetteurs (S) soit en multiplexage par répartition dans le temps, soit en multiplexage par répartition en fréquence,
h) par le fait que, soit, les allures des signaux, reçues par les éléments récepteurs (E) et mémorisées, de différents cycles de multiplexage sont comparées l'une à l'autre dans le circuit de traitement (33), étant précisé que des modifications appropriées des signaux conduisent à l'identification d'une ou de plusieurs touches manoeuvrées,
i) soit à chaque cycle de multiplexage une interrogation pour reconnaissance des touches (T) est déclenchée par les valeurs de seuil prescrites de façon fixe et correspondant aux différentes touches.

2. Clavier opto-électronique selon la revendication 1, caractérisé par le fait que, dans leurs parties (17) exposées, lors de la manoeuvre d'une touche, au trajet du faisceau entre un élément émetteur (S) et un élément récepteur (E), les tiges de touche (5) présentent une conformation telle que le faisceau divergent incident (24) est converti en un faisceau largement parallèle (25), sensiblement orienté parallèlement au capotage (3).

3. Clavier opto-électronique selon la revendication 2, caractérisé par le fait que dans l'élément de base (1) est disposé, sous chacune des touches, dans un évidement (2), un élément émetteur (S), et par le fait que la face inférieure (17) de la tige et l'environnement (22) de la tige de chaque touche sont conçus de façon telle que, si la touche n'est pas manoeuvrée, le faisceau émis par l'élément émetteur correspondant (S) est largement absorbé, tandis que si l'on enfonce la touche, le faisceau émis par l'élément émetteur (S) est, sur la tige, dévié parallèlement au capotage (3).

4. Clavier opto-électronique selon la revendication 2 ou 3, caractérisé par le fait que sur le trajet du faisceau lumineux dévié sur les tiges (5) des touches, au bord extérieur du clavier est disposé un réflecteur (23) par lequel le faisceau lumineux est dévié sur plusieurs éléments récepteurs (E₁) disposés dans l'élément de base de façon telle que le clavier présente plusieurs éléments émetteurs (S) et peu d'éléments récepteurs (E).

5. Clavier opto-électronique selon l'une des revendications 1 à 4, caractérisé par le fait que les éléments émetteurs (S) et les éléments récepteurs (E) sont constitués de diodes électro-luminescentes ou de détecteurs semi-conducteurs sensibles au rayonnement, ou bien sont conçus sous forme de capteurs sensibles à la chaleur ou bien sont disposés, en tant que composants semi-conducteurs montés en surface SMD, sur la feuille de base d'un commutateur en feuille ou sur un support de base.

6. Clavier opto-électronique selon l'une des revendications 1 à 5, caractérisé par le fait que les éléments émetteurs (S) et les éléments récepteurs (E) correspondant à chacune des touches sont logés dans un corps commun (37) servant d'élément de couplage dans la technique des dispositifs montés en surface SMD.

7. Clavier opto-électronique selon l'une des revendications précédentes, caractérisé par le fait que les éléments émetteurs (S) ou les éléments récepteurs (E) sont constitués des points terminaux (13) de câbles guides d'ondes (14) qui sont reliés à un circuit électronique extérieur d'activation et de traitement.

8. Clavier opto-électronique selon l'une des revendications précédentes, caractérisé par le fait que le blindage (2a, 2b) est constitué d'un revêtement mécanique ou d'une feuille de métal qui entoure l'ensemble de l'espace (9b) logeant le circuit électronique de traitement et présente des ouvertures pour l'entrée ou la sortie de la lumière.

9. Clavier opto-électronique selon l'une des revendications précédentes, caractérisé par le fait que les éléments émetteurs (S) sont activés en multiplexage par répartition en fréquence avec des fréquences différentes et par le fait que les mélanges de fréquences enregistrés par les éléments récepteurs (E) font, en ce qui concerne les proportions des différentes fréquences, l'objet d'essais dans un dispositif (32) de préparation du signal de sorte que des modifications de l'intensité des différentes fréquences du mélange de fréquences permettent de conclure à une modification de l'état de touches correspondantes.
